# EUROPEAN PATENT SPECIFICATION

(11) **EP 4 232 616 B1**
(45) Date of publication and mention of the grant of the patent: **04.12.2024**
(21) Application number: 20796756.3
(22) Date of filing: 21.10.2020
(51) Int. Cl.: B65H 27/00, C23C 14/56, C23C 14/54

(54) **DRUM DEVICE FOR USE IN A WEB COATING PROCESS, WEB COATING APPARATUS AND METHOD FOR CONTROLLING THE TEMPERATURE OF A WEB IN A WEB COATING PROCESS**
TROMMELVORRICHTUNG ZUR VERWENDUNG IN EINEM BAHNBESCHICHTUNGSVERFAHREN, BAHNBESCHICHTUNGSVORRICHTUNG UND VERFAHREN ZUR STEUERUNG DER TEMPERATUR EINER BAHN IN EINEM BAHNBESCHICHTUNGSVERFAHREN
DISPOSITIF À CYLINDRE POUR UTILISATION DANS UN PROCÉDÉ DE REVÊTEMENT DE BANDE, APPAREIL DE REVÊTEMENT DE BANDE ET PROCÉDÉ DE RÉGULATION DE LA TEMPÉRATURE D'UNE BANDE DANS UN PROCESSUS DE REVÊTEMENT DE BANDE

(43) Date of publication of application: 30.08.2023
(73) Proprietor: Applied Materials, Inc., Santa Clara, California 95054 (US)
(72) Inventor: HOFFMANN, Gerd, 63486 Bruchkoebel (DE); DIETER, Torsten Bruno, 63628 Bad Soden Salmünster (DE); DEPPISCH, Thomas, 63743 Aschaffenburg (DE); TRASSL, Roland, 35392 Giessen (DE)
(74) Representative: Zimmermann & Partner Patentanwälte mbB
(86) International application number: PCT/EP2020/079646
(87) International publication number: WO 2022/083857

(56) References cited:
- WO-A1-2017/207053
- US-A1- 2010 266 766
- US-A1- 2020 308 693

## Description

### TECHNICAL FIELD

Embodiments of the present disclosure relate to a drum device for guiding a web, a web coating apparatus and a method for controlling the temperature of a web. Embodiments of the present disclosure particularly relate to a drum device for guiding a web in a web coating process under vacuum conditions, a web coating apparatus comprising a vacuum chamber including the drum device, and a method for controlling the temperature of a web in a web coating process under vacuum conditions.

### BACKGROUND

In apparatuses and methods for coating a web, the web to be coated is guided by means of a web coating apparatus. For instance, the web may be guided past one or more deposition sources for depositing one or more layers of deposition material on the web. Under process conditions with high coating temperatures, however, some regions of the web may heat up excessively. Since in a vacuum environment cooling of the web by convection or radiation is strongly impaired, at high deposition rates, the web may be heated up to impermissible temperature values and thus be damaged or may even melt.

To overcome this situation, it is known that the drum supporting the web is cooled, wherein a high heat transfer coefficient (HTC) is supposed to be used. However, this represents a considerable restriction to the regular coating operation.

WO 2017/207053 A1 discloses a roller device for use in a web coating process under vacuum conditions having a temperature adjusting system, a rotatable curved surface facing the web, and gas outlets for releasing a gas flow into voids between points of contact between the web and the curved surface.

US 2020/0308693 A1 discloses a temperature control roller for a coating process in which a liquid-cooled roller guides a substrate. Heat transfer between the substrate and the roller surface is enhanced by introducing a gas into the space between them.

Accordingly, it would be beneficial to improve the cooling mechanism of a drum device for guiding a web in a web coating process under vacuum conditions while allowing for improved working conditions, such as cleaning efficiency, while the web is subject to fewer restrictions regarding the materials used.

### TERMS AND DEFINITIONS

This disclosure uses terms whose meaning is briefly explained here.

A drum as referred to herein may be a device which is rotationally symmetric about a rotation axis. The drum may be cylindrical or concave-cylindrical. The drum may also be a cone or a truncated cone. Typically, the drum is rotatable about the rotation axis. In some embodiments, the drum may include a stationary inner part and a rotary outer part, which rotates about the inner stationary part. Alternatively, the inner part can rotate with the outer part.

The terms axis and axial refer to a rotation axis of a rotatable element, especially of a drum. An axial direction refers to a direction parallel to the rotation axis. An axial extension of an element refers to the extension of the element along the rotation axis. The term radial refers to a direction perpendicular to the rotation axis.

A web as used within the embodiments described herein can typically be viewed as a flexible substrate characterized in that it is bendable. The term "web" may be synonymously used with the term "strip" or the term "flexible substrate". For example, the web, as described in embodiments herein, may be a foil, a plastic film or another flexible substrate.

The terms "inner area" and "outer area" refer to spaces that are complementary to each other. The term "outer area" refers to a space that is further away from the rotation axis of the drum in relation to a drum surface or a web than a space designated as "inner area".

The term "deposition device" may synonymously be used as "vapor deposition unit" or "evaporator unit" herein and may be understood as a device in a process used to turn a source material into the gaseous form of the source material, i.e. vapor. The source material can be turned first into a fluid form by a melting process and then turned into the gaseous form, or can be directly turned into the gaseous form.

The term "substantially" as used herein typically implies that there is a certain deviation, e.g. up to 1%, up to 3% or up to 10%, from the characteristic denoted with "substantially".

### SUMMARY

According to an aspect of the present disclosure, a drum device for guiding a web in a web coating process under vacuum conditions is provided. The drum device includes a rotatable drum with a web facing surface comprising a first web facing surface portion, and a gas distribution system for providing a gas flow including a gas composition into an interspace between the web and the first web facing surface portion denoted as a first interspace, the gas composition comprising a gas and/or a vapor of a liquid. The drum device further includes a temperature adjusting system adapted for controlling the temperature of the first web facing surface portion, such that the gas composition is cooled in a manner that the gas and/or the liquid changes the aggregate state, thus forming a non-gaseous cushion in the first interspace.

According to another aspect of the present disclosure, a web coating apparatus including a vacuum chamber and a deposition device is provided. The vacuum chamber includes the drum device. The deposition device is adapted for performing chemical vapor deposition, physical vapor deposition such as evaporation or sputtering, or plasma enhanced chemical vapor deposition.

According to another aspect of the present disclosure, a method for controlling the temperature of a web in a web coating process under vacuum conditions is provided. The method includes a) moving the web over a rotatable drum with a web facing surface comprising a first web facing surface portion, b) providing a gas flow including a gas composition into an interspace between the web and the first web facing surface portion denoted as a first interspace, the gas composition comprising a gas and/or a vapor of a liquid, and c) controlling the temperature of the gas composition in the first interspace such that the gas composition is cooled in a manner that the gas and/or the liquid changes the aggregate state, thus forming a non-gaseous cushion in the first interspace.

According to another aspect of the present disclosure, a method for coating a web under vacuum conditions is provided. The method includes controlling the temperature of the web as described herein; and depositing coating material on the web by chemical vapor deposition, physical vapor deposition such as evaporation or sputtering, or plasma enhanced chemical vapor deposition.

According to another aspect of the present disclosure, a controller is provided that includes a processor and a memory storing instructions that, when executed by the processor, cause a web coating apparatus to perform a method as described herein.

The drum device, the coating apparatus and the method for controlling temperature provide an improved concept for guiding a web in a web coating process under vacuum conditions, and allow for efficiently cooling the web during the coating process. The improved cooling efficiency impairs neither the cleaning efficiency of the drum, nor the use of a large diversity of web materials including webs with large thickness and/or low temperature stability.

Further aspects, advantages and features of the present disclosure are apparent from the dependent claims, the description and the accompanying drawings.

### BRIEF DESCRIPTION OF THE DRAWINGS

So that the manner in which the above recited features of the present disclosure can be understood in detail, a more particular description of the present disclosure, briefly summarized above, may be had by reference to typical embodiments. The accompanying drawings relate to embodiments of the present disclosure and are described in the following:
Fig. 1a, 1b show schematic views of a drum device for guiding a web in a web coating process under vacuum conditions according to embodiments described herein;
Fig. 1c shows a schematic view of a web coating apparatus according to embodiments described herein;
Fig. 2 shows a schematic view of a drum device for guiding a web in a web coating process under vacuum conditions according to embodiments described herein;
Fig. 3a shows a schematic view of a method for controlling the temperature of a web in a web coating process under vacuum conditions according to embodiments described herein; and
Fig. 3b shows a schematic view of a method for coating a web in a coating process under vacuum conditions according to embodiments described herein.

### DETAILED DESCRIPTION OF EMBODIMENTS

Reference will now be made in detail to the various embodiments of the present disclosure, one or more examples of which are illustrated in the figures. Within the following description of the drawings, the same reference numbers refer to the same components. Generally, only the differences with respect to individual embodiments are described. Each example is provided by way of explanation and is not meant as a limitation of the present disclosure. Features illustrated or described as part of one embodiment can be used on or in conjunction with other embodiments to yield yet a further embodiment. It is intended that the description includes such modifications and variations.

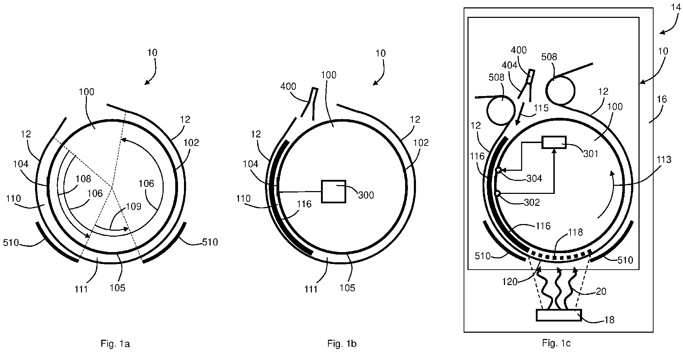

Fig. 1a, 1b show schematic views of an exemplary embodiment of a drum device for guiding a web in a web coating process under vacuum conditions. Fig. 1c shows a schematic view of an exemplary embodiment of a web coating apparatus. Details explained with illustrative reference to Fig. 1a, 1b, 1c shall not be understood as limited to the elements of Fig. 1a, 1b, 1c. Rather, those details may also be combined with further embodiments explained with illustrative reference to the other figures.

Fig. 1a is focused on the geometrical structure of the drum device 10 independently from a deposition process, whereas Figs. 1b and 1c show the drum device 10 during operation, i.e. during a deposition process.

The drum device 10 shown in Fig. 1a, 1b and 1c may include a rotatable drum 100 with a web facing surface 102 comprising a first web facing surface portion 104. A drum 100 as referred to herein may be a device which is rotationally symmetric about a rotation axis 114. The drum 100 may be cylindrical or concave-cylindrical. The drum 100 may also be a cone or a truncated cone. Typically, the drum 100 is rotatable about the rotation axis 114. In some embodiments, the drum 100 may include a stationary inner part 112 and a rotary outer part, which rotates about the inner stationary part 112. Alternatively, the inner part can rotate with the outer part.

The web facing surface or region 102 may be seen as a part or region of the drum surface that faces and/or guides the web 12. From the perspective of an observer along the rotation axis 114 of the drum 100, the web facing surface 102 can be viewed with an angular opening 106 that encloses the web facing surface 102 (see Fig. 1a). That means, the web facing surface 102 may extend along said angular opening 106.

The drum device 10 as described herein may further include a gas distribution system 400 for providing a gas flow 115 including a gas composition into an interspace between the web 12 and the first web facing surface portion 104. The interspace is denoted as a first interspace 110. The gas composition includes a gas and/or a vapor of a liquid.

The first web facing surface portion or region 104 may be seen as a part or region of the drum web facing surface 102, where the first web facing surface portion 104 and the facing area of the web 12 define or form a receiving volume or first interspace 110 that receives the gas flow 115. From the perspective of an observer along the rotation axis 114 of the drum 100, the first web facing surface portion 104 is viewed with an angular opening 108 encompassing the first web facing surface portion 104 (see Fig. 1a).

The angular extension of the first web facing surface portion 104 is preferably less than the angular extension of the web facing surface 102.

The axial extensions of the web facing surface 102 and of the first web facing surface portion 104 are substantially the same. Axially, the web facing surface 102 may extend along a span that i) encompasses the width of the web 12, and/or ii) is shorter or at most the same length as the axial extension of the drum 100.

In rotation direction 113 of the drum 100, the first web facing surface portion 104 is followed by a region of the drum surface termed second web facing surface portion 105. From the perspective of an observer along the rotation axis 114 of the drum 100, the second web facing surface can be viewed with an angular opening 109 that encloses the second web facing surface (see Fig. 1a). That means, the second web facing surface may extend along said angular opening 109. An interspace between the web 12 and the second web facing surface portion 105 is denoted as a second interspace 111. Advantageously, the non-gaseous cushion 116 transforms within the second interspace 111 into a gas cushion 118 designed to cool the web 12 when heat is applied from outside the drum 100.

The drum device 10 as described herein may further include a temperature adjusting system 300 adapted for controlling the temperature of the first web facing surface portion 104 such that the gas composition is cooled in a manner that the gas and/or the liquid changes the aggregate state within the first interspace 110, thus forming a non-gaseous cushion or medium 116, in the first interspace 110. In particular, the temperature adjusting system may be configured to cool at least parts of the drum, in particular the first web facing surface portion.

The non-gaseous cushion 116 within the first interspace 110 may be a solid or fluid cushion. The non-gaseous cushion 116 may extend at most to an angular edge and/or axial edge of the first web facing surface portion 104.

The liquid or solid cushion 116 allows the cooling medium to be transported to the interspace adjacent to the deposition area 120, i.e. the process area, without escaping during transportation. In contrast thereto, by use of a gas cushion, the gas stays trapped only shortly. The gas converted into a fluid or solid state however cannot escape and may efficiently be transported to the process area, in which it may change back to the gaseous state, due to the high temperature, and can provide a high heat transfer coefficient in the process area.

The web coating apparatus 14 shown in Fig. 1c may include a vacuum chamber 16 and a deposition device 18, the vacuum chamber 16 including the drum device 10. The deposition device 18 may be adapted for performing chemical vapor deposition, physical vapor deposition such as evaporation or sputtering, or plasma enhanced chemical vapor deposition.

The deposition device 18 may vaporize a source material and the vapor 20 generated may be forwarded to the web 12. After passing the shields 510, or rather the window formed by the shields 510, the vapor 20 may be deposited on the web 12. Especially in the area where material of the deposition vapor 20 is deposited on the web 12, a considerable amount of heat is applied to the web 12. It is therefore essential to ensure effective cooling of the web 12 in the deposition area 120. This is enabled by the gas cushion 118 within the second interspace 111 below the deposition area 120 of the web 12, the gas cushion 118 thus acting as a cooling cushion.

The deposition device 18 may transfer the material to be deposited onto the web 12 in a deposition area 120 of the web 12 which is adjacent to the second interspace 111. As a consequence of the heating related to the deposition process, the non-gaseous cushion 116 inside the first interspace 110 transforms into a gas cushion 118 inside the second interspace 111.

Drum devices wherein a gas cushion is formed in an interspace between web and drum regularly suffer from the problem that the gas does not remain in the interspace but instead dissipates out of the interspace. The gas remaining in the interspace is insufficient in quantity and is no longer able to achieve a sufficient cooling effect to the web. Thus, during the coating of the web, when heat is applied, the web may be damaged. In addition, also the drum may be contaminated, which is particularly bad if the drum has openings or pores that may get clogged.

The described obstacles are overcome by the concept of the present drum device 10, wherein a non-gaseous cushion 116 is built up inside the first interspace 110. The material of the non-gaseous cushion 116 inside first interspace 110 either does not escape from the first interspace 110 at all or at least to a much lesser extent. This causes a sufficient amount of gas to be left in the second interspace 111, allowing for a gas cushion 118 within the second interspace 111 providing improved cooling of the deposition area 120 of the web 12 onto which material is deposited in the deposition process.

The improved cooling enables the use of a wide range of web materials, including materials with a low thermal stability and/or temperature-sensitive web materials. Advantageously, due to the improved cooling, neither the HTC, nor the thickness of the web or of the deposition layer play a limiting role in the selection of the parameters of the coated web. In this way, a thick layer can also be deposited on the web 12, for example 1 µm, which is known to be 20 times thicker than classic layers for packaging with aluminum or copper.

With the present concept, damage to the web 12 due to insufficient cooling is substantially less probable, which also enables easy and efficient cleaning of the drum 100.

According to embodiments that can be combined with any other embodiments described herein, the temperature adjusting system 300 may be adapted for changing, in the first interspace 110, the aggregate state of the liquid to the solid state by freezing. Additionally or alternatively, the temperature adjusting system 300 may be adapted for changing, in the first interspace 110, the aggregate state of the gas to the solid state, especially by deposition. Additionally or alternatively, the temperature adjusting system 300 may be adapted for changing, in the first interspace 110, the aggregate state of the gas to the liquid state. When changing the aggregate state of the liquid or of the gas to the solid state, a solid cushion 116 may be created in the first interspace 110. When changing the aggregate state of the gas to the liquid state, a liquid cushion 116 may be created in the first interspace 110. The solid cushion shows even less dissipation than a liquid cushion, which in turn shows much less dissipation than a gaseous cushion.

According to embodiments that can be combined with any other embodiments described herein, no continuous layer or cushion is formed in the first interspace 110. Instead, the frozen vapor may fill the pores of the web 12 and/or surface of the drum 100. Thus, the gas composition may be trapped as frozen vapor and cannot escape such as in the known devices. Once the frozen vapor has melted, in a region following the second interspace 111 in the rotation direction 113, the gas composition may escape and may subsequently be pumped out.

In this document, the term "cushion" includes a gas composition being i) formed as a layer of frozen vapor or gas between drum surface 104 and web 12, and/or ii) deposited or trapped as frozen vapor or gas in the pores of the web 12 and/or drum surface 104.

The amount of material remaining in the solid cushion 116 within the first interspace 110 is large enough to allow a sufficient amount of material in the gas cushion 118 within the second interspace 111, thus enabling effective cooling of the web 12 in the region suffering from the heating related to the deposition process.

According to embodiments that can be combined with any other embodiments described herein, the temperature adjusting system 300 may be adapted for controlling the temperature of the gas flow 115 entering the first interspace 110. A control in the sense of heating the gas flow 115 may result in that the gas can be injected at high pressure without any state transition occurring before the gas has entered the first interspace 110. A control in the sense of cooling the injected gas flow 115 may result in a lower cooling requirement to achieve a solid gas cushion 116 within the first interspace 110.

According to embodiments that can be combined with any other embodiments described herein, the temperature adjusting system 300 may include a temperature sensing unit 302 adapted to measure the temperature of the gas composition and/or of the first web facing surface portion 104. The sensing unit may be, for example, an IR sensor located in an inner area of the drum 100.

According to embodiments that can be combined with any other embodiments described herein, the temperature adjusting system may include a temperature adjusting unit 304 adapted to adjust the temperature of the gas composition and/or of the first web facing surface portion 104. The temperature adjusting unit 304 may be based on liquid cooling, the drum 100 being provided with an array of passages around the drum perimeter.

According to embodiments that can be combined with any other embodiments described herein, the temperature adjusting system 300 may include a controller 301 connectable or connected to the temperature sensing unit 302 and/or the temperature adjusting unit 304. The controller 301 may be adapted to control the temperature of the gas composition within a predetermined temperature range. Compared to direct temperature actuation, the present control system can work more efficiently and save energy.

The controller may furthermore be configured to control the method for coating a web as described herein. The controller 301 may include a central processing unit (CPU), a memory and, for example, support circuits. To facilitate control of the temperature adjusting system, the CPU may be one of any form of general-purpose computer processor that can be used in an industrial setting for controlling various chambers and sub-processors. The memory is coupled to the CPU. The memory, or a computer readable medium, may be one or more readily available memory devices such as random access memory, read only memory, USB stick, hard disk, or any other form of digital storage either local or remote. The support circuits may be coupled to the CPU for supporting the processor in a conventional manner. These circuits include cache, power supplies, clock circuits, input/output circuitry and related subsystems, and the like. The software routine may also be stored and/or executed by a second CPU (not shown) that is remotely located from the hardware being controlled by the CPU. The software routine, when executed by the CPU, transforms the general-purpose computer into a specific purpose computer (controller) that controls the temperature adjustment. Although the method and/or process of the present disclosure is discussed as being implemented as a software routine, some of the method actions that are disclosed therein may be performed in hardware as well as by the software controller. As such, the invention may be implemented in software as executed upon a computer system, and in hardware as an application specific integrated circuit or other type of hardware implementation, or a combination of software and hardware.

According to embodiments that can be combined with any other embodiments described herein, the liquid may include at least one of a group including:
- water;
- liquefied gas;
- glycerol;
- alkyl hydrocarbon;
- ketones such as acetone, alcohols such as ispopropyl alcohol;
- polyol such as ethylene glycol, diethylene glycol, propylene glycol, glycerol;
- lower oligomer of glycerol, such as diglycerol or triglycerol.

Especially water and/or glycerol transform fast from gas to solid phase when hitting the coating drum, at a given temperature and pressure, thus being very well suited.

According to embodiments that can be combined with any other embodiments described herein, the gas may include at least one of a group including:
- alkanes such as methane, ethene, butane, propane;
- oxygen;
- carbon dioxide;
- nitrogen or air;

Especially gases with high momentum transfer (when masses are equal) are highly suitable.

According to embodiments that can be combined with any other embodiments described herein, the drum device 10 may include shields 510 located close to the web 12 in an outer area of the web 12. At least one shield may be located on each side of the second web facing surface portion 105, to define a window responsible for the passage of coating material to the web section vis-à-vis the second web facing surface portion 105. The shields 510 allow a desired and precisely defined amount of deposition material to be deposited through the window onto the web 12, which is advantageous in ensuring a desired and/or constant thickness of the layer deposited on the web 12. In addition, the shields 510 prevent heating of the web 12 outside the section vis-a-vis of the second web facing surface portion 105, which ensures that the gas cushion 118 in the second interspace 111 contains an amount of gas that is constant over time, thus preventing fluctuations in the cooling effect.

According to embodiments that can be combined with any other embodiments described herein, the gas distribution system 400 may include at least one nozzle 404-408 for providing a directed and/or metered supply of gas flow 115 into the first interspace 110. A "nozzle" as referred to herein may be understood as a device for guiding a gas, especially for controlling the direction or characteristics of the gas (such as the rate of flow, speed, shape, and/or the pressure of the gas that emerges from the nozzle). The nozzle may have an inlet for receiving the gas, a passage or channel for guiding the gas through the nozzle, and an outlet for releasing the gas. According to embodiments described herein, the channel of the nozzle may include a defined geometry for achieving the direction or characteristic of the gas flowing through the nozzle. According to some embodiments, a nozzle may be part of a distribution assembly, e.g. a distribution pipe or one or more point sources. Additionally or alternatively, a nozzle as described herein may be connectable or connected to the distribution assembly providing gas and may receive gas from the distribution assembly.

According to embodiments that can be combined with any other embodiments described herein, at least one nozzle, in the following denoted as t-nozzle 404, may be adapted for providing the gas flow 115 into the first interspace 110 tangentially or substantially tangentially with respect to the drum 100, i.e. to the drum surface.

According to an embodiment, the t-nozzle 404 may have a linear slot-shaped outlet adapted to inject the gas flow 115 into a feed zone or gap leading into the first interspace 110 and extending over at least part of the width of the web 12, preferably over the entire width of the web 12. The feed zone is formed when the web 12 is rolled onto the drum 100, at the entrance of the first interspace 110. A nozzle as described herein, and especially the t-nozzle 404 can be an air blade configured to provide a homogeneous gas jet into the infeed edge. The air blade may extend approximately over the entire first web facing portion.

According to another embodiment, the t-nozzle 404 may have a plurality of circular outlets arranged linearly side by side to provide a homogeneous or substantially homogeneous gas jet into the feed zone.

The t-nozzle 404 may be positioned at the beginning of the first interspace 110 with respect to the rotation direction 113 of the drum 100.

The linear slot-shaped outlet or the linear arrangement of circular outlets may be aligned parallel to the feed zone and located at a short distance from the feed zone. The two t-nozzle embodiments described above may be implemented separately or in combination with each other.

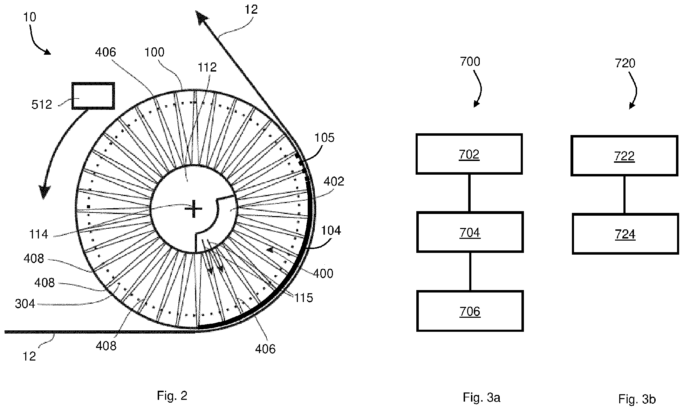

Fig. 2 shows a schematic view of a drum device 10 for guiding a web 12 in a web coating process under vacuum conditions. Details explained with illustrative reference to Fig. 2 shall not be understood as limited to the elements of Fig. 2. Rather, those details may also be combined with further embodiments explained with illustrative reference to the other figures.

According to embodiments described herein, the gas distribution system 400 may comprise at least one nozzle, in the following denoted as r-nozzle 406, 408, of which the outlet is disposed in the drum surface and adapted for providing the gas flow 115 into the first interspace 110 radially or substantially radially with respect to the drum 100 or the drum surface. The embodiment of Fig. 2 is focused on the design and function of r-nozzles within the drum device 10 alternatively to t-nozzles shown in Fig. 1b and 1c. However, the features already explained with reference to Figs. 1a-1c, even not shown with all details in Fig. 2 for the sake of clarity, may be combined with the features explained with reference to Fig. 2.

The r-nozzles 406, 408 may be adapted to release gas from the gas distribution system 400 in a direction substantially perpendicular to the drum surface at positions where the respective r-nozzle 406, 408 is located. In the example shown in Fig. 2, the r-nozzles 406, 408 are distributed over the surface of the drum 100. In particular, the r-nozzles 406, 408 are distributed in a regular manner over the surface of the drum 100.

The feature "disposed in a regular manner" may imply that the distance of a first r-nozzle and at least one neighbor r-nozzle of the first r-nozzle is substantially identical to the distance of a second r-nozzle with respect to at least one neighbor of the second r-nozzle. In some embodiments, the feature "disposed in a regular manner" may refer to a surface wherein a specific pattern can be assigned to a portion of the multitude of r-nozzles and the same pattern can be assigned to another portion of the multitude of r-nozzles. In some embodiments, the r-nozzles may be disposed in an irregular manner over the circumference of the drum 100.

According to embodiments which can be combined with any other embodiments described herein, any nozzle outlet can be selected from the group consisting of: openings, holes, slits, blast pipes, spray valves, duct openings, orifices, jets, outlets provided by a porous material and the like. According to some embodiments, a nozzle outlet as referred to herein may have any suitable shape, such as substantially round, circular, elliptic, triangular, rectangular, quadratic, a polygon, an irregular shape, such as an irregular round shape, an irregular angled shape, a shape being different from one gas outlet to the other, or the like. According to some embodiments, the r-nozzle outlets do not protrude out of the drum surface.

According to embodiments which can be combined with any other embodiments described herein, a gas source 402 may be provided. The gas source 402 may be part of the distribution system 400, as shown in Fig. 2, or of the web coating apparatus 14 according to Fig. 1c, in which the gas source is not shown.

According to embodiments which can be combined with any other embodiments described herein, the r-nozzles may comprise a first subgroup of r-nozzles 406 consisting of at least one r-nozzle of which the outlet is in the first web facing surface portion 104 and a second subgroup of r-nozzles 408 consisting of at least one r-nozzle of which the outlet is outside the first web facing surface portion 104.

According to embodiments which can be combined with any other embodiments described herein, the gas distribution system 400 may be configured for providing the gas flow 115 to the first subgroup of r-nozzles 406 and for preventing the gas from flowing to the second subgroup of r-nozzles 408.

The gas distribution system 400 may allow for selectively providing a gas flow 115 to the first subgroup of the r-nozzles 406. The r-nozzles 406 that are (temporarily) located in the first web facing surface portion 104 belong to the first subgroup of the r-nozzles 406.

During operation, the membership of any single r-nozzle to the first or second subgroup may change. In other words, an open r-nozzle may be closed at a later time and vice versa. In some embodiments, membership of the gas outlets to the first and/or second subgroup is changed during operation dependent on the rotational position of the drum surface. The first web facing surface portion 104 may remain at a fixed position in space, and gas r-nozzles entering the first web facing surface portion 104 due to the rotation of the drum surface are opened (or connected to the gas source 402), i.e., the membership is changed to the first subgroup. R-nozzles leaving the first web facing surface portion 104 due to the rotation of the drum surface are closed (or disconnected from the gas source 402), i.e., the membership is changed to the second subgroup.

The gas distribution system 400 of the drum 100 according to some embodiments described herein may be adapted to selectively provide and prevent gas flow in defined r-nozzles by the size, location, shape and construction, kinetic properties of the gas distribution system 400 and the like. For instance, in the example of Fig. 2, the gas distribution system 400 may include a gas source 402 arranged in or presenting a stationary part 112 of the drum 100. The gas source 402 may have a size encompassing a section of the circumference of the stationary part 112 of the drum 100. The drum surface may rotate about the rotation axis 114 of the drum 100 and, in particular, about the stationary part 112 of the drum 100 (including e.g. the gas source 402).

According to some embodiments described herein, the gas channels of the r-nozzles leading from the gas source 402 to the first subgroup of r-nozzles 406 when the respective r-nozzle is in the first web facing surface portion 104 may be conducting. The gas channels lead from the gas source 402 to the second subgroup of r-nozzles when the respective r-nozzle is outside the first web facing surface portion 104 may be non-conducting. The gas distribution system 400 with a gas source 402 and gas channels may be described as being partially rotary (e.g. the gas channels) and partly stationary (e.g. the gas source 402). With the gas channels rotating about the gas source 402, the gas distribution system 400 allows to selectively connect and disconnect the gas channels to the gas source 402.

According to some embodiments, the gas distribution system 400, and in particular the gas source 402 provides a gas flow 115 to the r-nozzles 406 (as exemplarily shown by two arrows in Fig. 2). In some embodiments, the gas flow 115 provided by the gas distribution system 400 to the r-nozzles 406 is a gas flow 115 still allowing the web 12 to be in contact (at least in punctual contact) with the drum surface. For instance, the gas flow 115 may typically be between about 10 sccm and about 400sccm, more typically between about 20 sccm and about 300 sccm, and even more typically between about 30 sccm and about 150 sccm.

The gas distribution system 400 according to embodiments described herein may be adapted to provide a flow rate of the gas per area of the drum surface typically between about 10 sccm/m2 and about 200 sccm/ m2, more typically between about 20 sccm/ m2 and about 150 sccm/ m2, and even more typically between about 30 sccm/ m2 and about 120 sccm/ m2. In one example, the gas distribution system 400 may be adapted to provide a flow rate of the gas per area of the drum surface which may typically be about 100 sccm/ m2.

According to some embodiments, which may be combined with other embodiments described herein, the gas distribution system 400 may be adapted to provide a defined gas flow rate by one or more parameter, such as for instance number or size of the r-nozzles, fluid conductance of the gas distribution system 400, size or capacity of the gas source 402, size and power of a pumping system for the gas, size and design of gas channels, and/or the like.

According to some embodiments, which may be combined with other embodiments described herein, the number of r-nozzles may typically be between 20 and 100, more typically between 30 and 100, and even more typically between 40 and 100, in particular for a drum device 10 with gas channels (as exemplarily shown in Fig. 2). According to some embodiments, the drum surface may be partitioned into gas sections. In some embodiments, each gas section has several r-nozzles. In some embodiments, the number of r-nozzles in the first web facing surface portion 104 may be between 5 and 20.

According to some embodiments, which may be combined with other embodiments described herein, an r-nozzle may have a cross-section size of typically between about 0.01 mm and about 1mm. The cross-section size may be measured as the minimum cross-section of the r-nozzles at the drum surface. In some embodiments, the fluid conductance of the r-nozzles may typically be between about 0.001 liter/sec and about 0.1 liter/sec, more typically between about 0.005 liter/sec and about 0.08 liter/sec, and even more typically between about 0.009 liter/sec and about 0.05 liter/sec. In one embodiment, the fluid conductance of the r-nozzles may be about 0.01 liter/sec.

According to some embodiments, which may be combined with other embodiments described herein, the drum device 10 may include a driving unit 512 for rotating the drum 100 and/or smaller deflection drums 508. The drum 100 may guide the web 12 in cooperation with the deflection drums 508, with the deflection drums ensuring sufficient web 12 tension and improved guiding behavior.

Fig. 3a shows a schematic view of a method for controlling the temperature of a web 12 in a web coating process under vacuum conditions. Details explained with illustrative reference to Fig. 3a shall not be understood as limited to the elements of Fig. 3a. Rather, those details may also be combined with further embodiments explained with illustrative reference to the other figures.

The method 700 for controlling the temperature of a web 12 in a web coating process under vacuum conditions may include:
- moving 702 the web 12 over a rotatable drum 100 with a web facing surface 102 comprising a first web facing surface portion 104;
- providing 704 a gas flow 115 including a gas composition into an interspace between the web 12 and the first web facing surface portion 104 denoted as a first interspace 110, the gas composition comprising a gas and/or a vapor of a liquid; and
- controlling 706 the temperature of the gas composition in the first interspace 110 such that the gas composition is cooled in a manner that the gas and/or the liquid changes the aggregate state, thus forming a non-gaseous cushion 116 in the first interspace 110.

Fig. 3b shows a schematic view of a method for coating a web 12 in a coating process under vacuum conditions. Details explained with illustrative reference to Fig. 3b shall not be understood as limited to the elements of Fig. 3b. Rather, those details may also be combined with further embodiments explained with illustrative reference to the other figures.

The method 720 for coating a web 12 in a coating process under vacuum conditions may include:
- controlling 722 the temperature of the web 12 according to the method of any of the preceding two claims; and
- depositing 724 coating material on the web 12 by chemical vapor deposition, physical vapor deposition such as evaporation or sputtering, or plasma enhanced chemical vapor deposition.

This written description uses examples to disclose the disclosure, including the best mode, and also to enable any person skilled in the art to practice the described subject-matter, including making and using any apparatus or system and performing any incorporated methods. Embodiments described herein provide an improved cooling mechanism of a drum device for guiding a web in a web coating process under vacuum conditions while allowing for improved working conditions, such as cleaning efficiency, while the web is subject to fewer restrictions regarding the materials used. While various specific embodiments have been disclosed in the foregoing, mutually non-exclusive features of the embodiments described above may be combined with each other. The patentable scope is defined by the claims, and other examples are intended to be within the scope of the claims if they have structural elements that do not differ from the literal language of the claims, or if they include equivalent structural elements with insubstantial differences from the literal language of the claims.

## Claims

1. A drum device (10) for guiding a web (12) in a web coating process under vacuum conditions, comprising:
- a rotatable drum (100) with a web facing surface (102) comprising a first web facing surface portion (104);
- a gas distribution system (400) for providing a gas flow (115) including a gas composition into an interspace between the web (12) and the first web facing surface portion (104) denoted as a first interspace (110), the gas composition comprising a gas and/or a vapor of a liquid; and
- a temperature adjusting system (300) adapted for controlling the temperature of the first web facing surface portion (104) such that the gas composition is cooled in a manner that the gas and/or the liquid changes the aggregate state, thus forming a non-gaseous cushion (116) in the first interspace (110).

2. The drum device (10) according to claim 1, wherein
the temperature adjusting system (300) is adapted to change, in the first interspace (110), i) the aggregate state of the liquid to a solid state by freezing and/or ii) the aggregate state of the gas to a solid state and/or iii) the aggregate state of the gas to the liquid state, wherein in particular; and/or
the non-gaseous cushion is formed as a solid cushion (116); and/or
the non-gaseous cushion is formed as a fluid cushion.

3. The drum device (10) according to any of the preceding claims, wherein the temperature adjusting system (300) comprises
a temperature sensing unit (302) adapted to measure the temperature of the gas composition and/or of the first web facing surface portion (104); and/or
a temperature adjusting unit (304) adapted to adjust the temperature of the gas composition and/or of the first web facing surface portion (104); and/or
a controller (300) connectable or connected to the temperature sensing unit (302) and/or the temperature adjusting unit (304), the controller being (300) adapted to control the temperature of the gas composition within a predetermined temperature range.

4. The drum device (10) according to any of the preceding claims, wherein
the liquid comprises at least one of a group including: water; liquefied gas; glycerol; alkyl hydrocarbon; ketones such as acetone, alcohols such as ispopropyl alcohol; polyol such as ethylene glycol, diethylene glycol, propylene glycol, glycerol; lower oligomer of glycerol, such as diglycerol or triglycerol, and/or
the gas comprises at least one of a group including: alkanes such as methane, ethene, butane, propane; oxygen; carbon dioxide; nitrogen.

5. The drum device (10) according to any of the preceding claims, wherein
the drum (100) comprises a second web facing surface portion (105) following the first web facing surface portion (104) in rotation direction (113) of the drum (100), an interspace between the web (12) and the second web facing surface portion (105) being denoted as a second interspace (111), wherein the cushion within the second interspace (111) is a gas cushion (118) designed to cool the web (12) when heat is applied from outside the drum (100).

6. The drum device (10) according to any of the preceding claims, wherein
the drum device (10) comprises shields (510) located close to the web (12) in an outer area of the web (12), at least one on each side of the second web facing surface portion (105), to define a window responsible for the passage of vapor (20) including coating material to the web section vis-à-vis the second web facing surface portion (105).

7. The drum device (10) according to any of the preceding claims, wherein
the gas distribution system (400) comprises at least one nozzle denoted as t-nozzle (404) adapted for providing a directed and/or metered supply of gas flow (115) into the first interspace (110) tangentially or substantially tangentially with respect to the drum surface; and/or
the t-nozzle (404) is positioned at the beginning of the first interspace (110) with respect to a rotation direction (113) of the drum (100).

8. The drum device (10) according to any of the preceding claims, wherein
the drum device (10) comprises a driving unit for rotating the drum (100).

9. The drum device (10) according to any of the claims 7 or 8, wherein
the gas distribution system (400) comprises one or more tangential gas channels, each in fluid communication with one of the t-nozzles (404).

10. Web coating apparatus (14) comprising a vacuum chamber (16) including the drum device (10) of any of the previous claims and a deposition device (18) adapted for performing chemical vapor deposition, physical vapor deposition such as evaporation or sputtering, or plasma enhanced chemical vapor deposition.

11. Web coating apparatus (14) according to the preceding claim, wherein
the non-gaseous cushion within the second interspace (111) is designed to transform into a gas cushion (118) during a deposition process applying heat on the web (12).

12. Method for controlling the temperature of a web (12) in a web coating process under vacuum conditions, comprising:
- moving the web (12) over a rotatable drum (100) with a web facing surface (102) comprising a first web facing surface portion (104);
- providing a gas flow (115) including a gas composition into an interspace between the web (12) and the first web facing surface portion (104) denoted as a first interspace (110), the gas composition comprising a gas and/or a vapor of a liquid; and
- controlling the temperature of the gas composition in the first interspace (110) such that the gas composition is cooled in a manner that the gas and/or the liquid changes the aggregate state, thus forming a non-gaseous cushion (116) in the first interspace (110).

13. Method according to the preceding claim, comprising at least one of:
changing the aggregate state i) of the liquid to the solid state by freezing and/or ii) of the gas to the solid state by deposition;
controlling the temperature of the first web facing surface portion (104) is performed by controlling the temperature of the drum (100) or the underlying drum portion;
rotating the drum (100) by a driving unit, wherein the web facing surface (102) comprises a web guiding region outside the first web facing surface portion (104) such that rotating the web guiding region induces moving the web (12);
forming the non-gaseous cushion as a solid cushion (116);
transforming the non-gaseous cushion within a second interspace (111) into a gas cushion (118) during a deposition process applying heat on the web (12), the second interspace (111) following the first interspace (110) in rotation direction (113) of the drum (100);
cooling the web (12) during a deposition process applying heat on the web (12) by means of the gas cushion (118).

14. Method for coating a web (12) in a coating process under vacuum conditions comprising:
- controlling the temperature of the web (12) according to the method of any of the preceding two claims; and
- depositing coating material on the web (12) by chemical vapor deposition, physical vapor deposition such as evaporation or sputtering, or plasma enhanced chemical vapor deposition.

15. A controller comprising: a processor and a memory storing instructions that, when executed by the processor, cause a web coating apparatus to perform a method according to any of claims 12 to 14.

## Patentansprüche

1. Trommelvorrichtung (10) zum Führen einer Bahn (12) in einem Bahnbeschichtungsprozess unter Vakuumbedingungen, umfassend:
- eine drehbare Trommel (100) mit einer der Bahn zugewandten Oberfläche (102), die einen ersten der Bahn zugewandten Oberflächenabschnitt (104) umfasst;
- ein Gasverteilungssystem (400) zum Bereitstellen eines Gasstroms (115), der eine Gaszusammensetzung aufweist, in einen Zwischenraum zwischen der Bahn (12) und dem ersten der Bahn zugewandten Oberflächenabschnitt (104), der als erster Zwischenraum (110) bezeichnet wird, wobei die Gaszusammensetzung ein Gas und/oder einen Dampf einer Flüssigkeit umfasst; und
- ein Temperatureinstellsystem (300), das so beschaffen ist, dass es die Temperatur des ersten der Bahn zugewandten Oberflächenabschnitts (104) so steuert, dass die Gaszusammensetzung so abgekühlt wird, dass das Gas und/oder die Flüssigkeit den Aggregatzustand ändert, wodurch ein nicht gasförmiges Kissen (116) in dem ersten Zwischenraum (110) gebildet wird.

2. Trommelvorrichtung (10) nach Anspruch 1, wobei
das Temperatureinstellsystem (300) angepasst ist, um in dem ersten Zwischenraum (110) i) den Aggregatzustand der Flüssigkeit durch Gefrieren in einen festen Zustand und/oder ii) den Aggregatzustand des Gases in einen festen Zustand und/oder iii) den Aggregatzustand des Gases in den flüssigen Zustand zu ändern, wobei insbesondere; und/oder
das nicht gasförmige Kissen als festes Kissen (116) ausgebildet ist; und/oder
das nicht-gasförmige Kissen als Flüssig-Kissen ausgebildet ist.

3. Trommelvorrichtung (10) nach einem der vorhergehenden Ansprüche, wobei das Temperatureinstellsystem (300) umfasst
eine Temperaturerfassungseinheit (302), die die Temperatur der Gaszusammensetzung und/oder des ersten der Bahn zugewandten Oberflächenabschnitts (104) messen kann; und/oder
eine Temperatureinstelleinheit (304), die dazu geeignet ist, die Temperatur der Gaszusammensetzung und/oder des ersten der Bahn zugewandten Oberflächenabschnitts (104) einzustellen; und/oder
eine Steuereinheit (300), die mit der Temperaturerfassungseinheit (302) und/oder der Temperatureinstelleinheit (304) verbindbar oder verbunden ist, wobei die Steuereinheit (300) die Temperatur der Gaszusammensetzung innerhalb eines vorbestimmten Temperaturbereichs steuern kann.

4. Trommelvorrichtung (10) nach einem der vorhergehenden Ansprüche, wobei
die Flüssigkeit mindestens eines umfasst aus der Gruppe, das Wasser, Flüssiggas, Glycerin, Alkylkohlenwasserstoff, Ketone wie Aceton, Alkohole wie Isopropylalkohol, Polyol wie Ethylenglykol, Diethylenglykol, Propylenglykol, Glycerin, niederes Oligomer von Glycerin wie Diglycerin oder Triglycerin umfasst und/oder
das Gas mindestens eines umfasst aus einer Gruppe, welche Alkane wie Methan, Ethen, Butan, Propan, Sauerstoff, Kohlendioxid und Stickstoff umfasst.

5. Trommelvorrichtung (10) nach einem der vorhergehenden Ansprüche, wobei
die Trommel (100) einen zweiten, der Bahn zugewandten Oberflächenabschnitt (105) aufweist, der dem ersten, der Bahn zugewandten Oberflächenabschnitt (104) in Drehrichtung (113) der Trommel (100) folgt, wobei ein Zwischenraum zwischen der Bahn (12) und dem zweiten, der Bahn zugewandten Oberflächenabschnitt (105) als zweiter Zwischenraum (111) bezeichnet wird, wobei das Kissen innerhalb des zweiten Zwischenraums (111) ein Gaspolster (118) ist, das dazu bestimmt ist, die Bahn (12) zu kühlen, wenn Wärme von außerhalb der Trommel (100) zugeführt wird.

6. Trommelvorrichtung (10) nach einem der vorhergehenden Ansprüche, wobei
die Trommelvorrichtung (10) Abschirmungen (510) umfasst, die nahe der Bahn (12) in einem äußeren Bereich der Bahn (12) angeordnet sind, mindestens eine auf jeder Seite des zweiten der Bahn zugewandten Oberflächenabschnitts (105), um ein Fenster zu definieren, das für den Durchgang von Dampf (20), der Beschichtungsmaterial aufweist, zum Bahnabschnitt gegenüber dem zweiten der Bahn zugewandten Oberflächenabschnitt (105) verantwortlich ist.

7. Trommelvorrichtung (10) nach einem der vorhergehenden Ansprüche, wobei
das Gasverteilungssystem (400) mindestens eine als t-Düse (404) bezeichnete Düse umfasst, die geeignet ist, eine gerichtete und/oder dosierte Zufuhr von Gasströmung (115) in den ersten Zwischenraum (110) tangential oder im Wesentlichen tangential in Bezug auf die Trommeloberfläche bereitzustellen; und/oder
die t-Düse (404) am Anfang des ersten Zwischenraums (110) in Bezug auf eine Drehrichtung (113) der Trommel (100) angeordnet ist.

8. Trommelvorrichtung (10) nach einem der vorhergehenden Ansprüche, wobei
die Trommelvorrichtung (10) eine Antriebseinheit zum Drehen der Trommel (100) umfasst.

9. Trommelvorrichtung (10) nach einem der Ansprüche 7 oder 8, wobei
das Gasverteilungssystem (400) einen oder mehrere tangentiale Gaskanäle umfasst, die jeweils in Fluidverbindung mit einer der t-Düsen (404) stehen.

10. Bahnbeschichtungsvorrichtung (14) umfassend eine Vakuumkammer (16), die die Trommelvorrichtung (10) nach einem der vorhergehenden Ansprüche aufweist, und einer Abscheidungsvorrichtung (18), die für die Durchführung der chemischen Gasabscheidung, der physikalischen Gasabscheidung, wie Verdampfung oder Sputtern, oder der plasmaunterstützten chemischen Gasabscheidung geeignet ist.

11. Bahnbeschichtungsvorrichtung (14) nach dem vorhergehenden Anspruch, wobei
das nicht gasförmige Kissen innerhalb des zweiten Zwischenraums (111) so ausgelegt ist, dass es sich während eines Abscheidungsprozesses, bei dem Wärme auf die Bahn (12) aufgebracht wird, in ein Gaskissen (118) transformiert.

12. Verfahren zum Steuern der Temperatur einer Bahn (12) in einem Bahnbeschichtungsprozess unter Vakuumbedingungen, umfassend:
- Bewegen der Bahn (12) über eine drehbare Trommel (100) mit einer der Bahn zugewandten Oberfläche (102), die einen ersten der Bahn zugewandten Oberflächenabschnitt (104) aufweist;
- Bereitstellen eines Gasstroms (115), der eine Gaszusammensetzung aufweist, in einem Zwischenraum zwischen der Bahn (12) und dem ersten der Bahn zugewandten Oberflächenabschnitt (104), der als erster Zwischenraum (110) bezeichnet wird, wobei die Gaszusammensetzung ein Gas und/oder einen Dampf einer Flüssigkeit umfasst; und
- Steuern der Temperatur der Gaszusammensetzung in dem ersten Zwischenraum (110) derart, dass die Gaszusammensetzung in einer Weise gekühlt wird, dass das Gas und/oder die Flüssigkeit den Aggregatzustand ändert, wodurch ein nicht gasförmiges Kissen (116) in dem ersten Zwischenraum (110) gebildet wird.

13. Verfahren nach dem vorhergehenden Anspruch, umfassend mindestens eines von:
Ändern des Aggregatzustands i) der Flüssigkeit in den festen Zustand durch Gefrieren und/oder ii) des Gases in den festen Zustand durch Abscheidung;
Steuern der Temperatur des ersten der Bahn zugewandten Oberflächenabschnitts (104) wird durch Steuern der Temperatur der Trommel (100) oder des darunter liegenden Trommelabschnitts durchgeführt;
Drehen der Trommel (100) durch eine Antriebseinheit, wobei die der Bahn zugewandten Oberfläche (102) einen bahnführenden Abschnitt außerhalb des ersten der Bahn zugewandten Oberflächenabschnitts (104) umfasst, so dass das Drehen des bahnführenden Abschnitts eine Bewegung der Bahn (12) bewirkt;
Ausbilden des nicht gasförmigen Kissens als festes Kissen (116);
Umwandlung des nicht gasförmigen Kissens innerhalb eines zweiten Zwischenraums (111) in ein Gaskissen (118) während eines Abscheidungsprozesses, bei dem Wärme auf die Bahn (12) aufgebracht wird, wobei der zweite Zwischenraum (111) dem ersten Zwischenraum (110) in Drehrichtung (113) der Trommel (100) folgt;
Kühlen der Bahn (12) während eines Abscheidungsprozesses, bei dem Wärme auf die Bahn (12) mittels des Gaskissens (118) aufgebracht wird.

14. Verfahren zum Beschichten einer Bahn (12) in einem Beschichtungsprozess unter Vakuumbedingungen, umfassend:
- Steuern der Temperatur der Bahn (12) gemäß dem Verfahren nach einem der beiden vorhergehenden Ansprüche; und
- Abscheiden von Beschichtungsmaterial auf der Bahn (12) durch chemische Gasabscheidung, physikalische Gasabscheidung, wie Verdampfung oder Sputtern, oder plasmaunterstützte chemische Gasabscheidung.

15. Steuergerät umfassend: einen Prozessor und einen Speicher, der Anweisungen speichert, die, wenn sie vom Prozessor ausgeführt werden, eine Bahnbeschichtungsvorrichtung veranlassen, ein Verfahren nach einem der Ansprüche 12 bis 14 durchzuführen.

## Revendications

1. Dispositif à tambour (10) permettant de guider une bande (12) dans un processus de revêtement de bande dans des conditions sous vide, comprenant :
- un tambour rotatif (100) avec une surface faisant face à la bande (102) comprenant une première partie de surface faisant face à la bande (104) ;
- un système de distribution de gaz (400) permettant de fournir un flux de gaz (115) comportant une composition de gaz dans un espace intermédiaire entre la bande (12) et la première partie de surface faisant face à la bande (104) désigné premier espace intermédiaire (110), la composition de gaz comprenant un gaz et/ou une vapeur d'un liquide ; et
- un système d'ajustement de température (300) conçu pour réguler la température de la première partie de surface faisant face à la bande (104) de telle sorte que la composition de gaz est refroidie d'une manière telle que le gaz et/ou le liquide changent d'état d'agrégation, formant ainsi un coussin non gazeux (116) dans le premier espace intermédiaire (110).

2. Dispositif à tambour (10) selon la revendication 1, dans lequel
le système d'ajustement de température (300) est conçu pour changer, dans le premier espace intermédiaire (110), i) l'état d'agrégation du liquide vers un état solide par congélation et/ou ii) l'état d'agrégation du gaz vers un état solide et/ou iii) l'état d'agrégation du gaz vers l'état liquide, dans lequel en particulier ; et/ou
le coussin non gazeux est formé en tant que coussin solide (116) ; et/ou
le coussin non gazeux est formé en tant que coussin fluide.

3. Dispositif à tambour (10) selon l'une quelconque des revendications précédentes, dans lequel le système d'ajustement de température (300) comprend
une unité de détection de température (302) conçue pour mesurer la température de la composition de gaz et/ou de la première partie de surface faisant face à la bande (104) ; et/ou
une unité d'ajustement de température (304) conçue pour ajuster la température de la composition de gaz et/ou de la première partie de surface faisant face à la bande (104) ; et/ou
un dispositif de commande (300) pouvant être connecté ou étant connecté à l'unité de détection de température (302) et/ou à l'unité d'ajustement de température (304), le dispositif de commande (300) étant conçu pour réguler la température de la composition de gaz au sein d'une plage de température prédéterminée.

4. Dispositif à tambour (10) selon l'une quelconque des revendications précédentes, dans lequel
le liquide comprend au moins l'un parmi un groupe comportant : eau ; gaz liquéfié ; glycérol ; hydrocarbure d'alkyle ; cétones telles qu'acétone, alcools tels qu'alcool isopropylique ; polyol tel qu'éthylène glycol, diéthylène glycol, propylène glycol, glycérol ; oligomère inférieur de glycérol, tel que diglycérol ou triglycérol, et/ou
le gaz comprend au moins l'un parmi un groupe comportant : alcanes tels que méthane, éthène, butane, propane ; oxygène ; dioxyde de carbone ; azote.

5. Dispositif à tambour (10) selon l'une quelconque des revendications précédentes, dans lequel
le tambour (100) comprend une seconde partie de surface faisant face à la bande (105) à la suite de la première partie de surface faisant face à la bande (104) dans une direction de rotation (113) du tambour (100), un espace intermédiaire entre la bande (12) et la seconde partie de surface faisant face à la bande (105) étant désigné second espace intermédiaire (111), dans lequel le coussin au sein du second espace intermédiaire (111) est un coussin de gaz (118) destiné à refroidir la bande (12) lorsque de la chaleur est appliquée depuis l'extérieur du tambour (100).

6. Dispositif à tambour (10) selon l'une quelconque des revendications précédentes, dans lequel
le dispositif à tambour (10) comprend des écrans (510) localisés près de la bande (12) dans une zone externe de la bande (12), au moins un de chaque côté de la seconde partie de surface faisant face à la bande (105), pour définir une fenêtre responsable du passage de vapeur (20) comportant un matériau de revêtement vers la section de bande vis-à-vis de la seconde partie de surface faisant face à la bande (105).

7. Dispositif à tambour (10) selon l'une quelconque des revendications précédentes, dans lequel
le système de distribution de gaz (400) comprend au moins une buse désignée buse en t (404) conçue pour fournir une alimentation dirigée et/ou dosée de flux de gaz (115) dans le premier espace intermédiaire (110) tangentiellement ou de manière sensiblement tangentielle par rapport à la surface de tambour ; et/ou
la buse en t (404) est positionnée au début du premier espace intermédiaire (110) par rapport à une direction de rotation (113) du tambour (100).

8. Dispositif à tambour (10) selon l'une quelconque des revendications précédentes, dans lequel
le dispositif à tambour (10) comprend une unité d'entraînement permettant de mettre en rotation le tambour (100).

9. Dispositif à tambour (10) selon l'une quelconque des revendications 7 ou 8, dans lequel
le système de distribution de gaz (400) comprend un ou plusieurs canaux de gaz tangentiels, chacun en communication fluidique avec l'une des buses en t (404).

10. Appareil de revêtement de bande (14) comprenant une chambre à vide (16) comportant le dispositif à tambour (10) selon l'une quelconque des revendications précédentes et un dispositif de dépôt (18) conçu pour effectuer un dépôt chimique en phase vapeur, un dépôt physique en phase vapeur tel qu'évaporation ou pulvérisation, ou un dépôt chimique en phase vapeur assisté par plasma.

11. Appareil de revêtement de bande (14) selon la revendication précédente, dans lequel
le coussin non gazeux au sein du second espace intermédiaire (111) est conçu pour se transformer en un coussin de gaz (118) pendant un processus de dépôt appliquant de la chaleur sur la bande (12).

12. Procédé permettant de commander la température d'une bande (12) dans un processus de revêtement de bande dans des conditions sous vide, comprenant :
- le déplacement de la bande (12) par-dessus un tambour rotatif (100) avec une surface faisant face à la bande (102) comprenant une première partie de surface faisant face à la bande (104) ;
- la fourniture d'un flux de gaz (115) comportant une composition de gaz dans un espace intermédiaire entre la bande (12) et la première partie de surface faisant face à la bande (104) désigné premier espace intermédiaire (110), la composition de gaz comprenant un gaz et/ou une vapeur d'un liquide ; et
- la régulation de la température de la composition de gaz dans le premier espace intermédiaire (110) de telle sorte que la composition de gaz est refroidie d'une manière telle que le gaz et/ou le liquide changent d'état d'agrégation, formant ainsi un coussin non gazeux (116) dans le premier espace intermédiaire (110).

13. Procédé selon la revendication précédente, comprenant au moins l'un parmi :
un changement de l'état d'agrégation i) du liquide vers l'état solide par congélation et/ou ii) du gaz vers l'état solide par dépôt ;
la régulation de la température de la première partie de surface faisant face à la bande (104) est effectuée en régulant la température du tambour (100) ou de la partie sous-jacente de tambour ;
la rotation du tambour (100) par une unité d'entraînement, dans lequel la surface faisant face à la bande (102) comprend une région de guidage de bande à l'extérieur de la première partie de surface faisant face à la bande (104) de telle sorte qu'une rotation de la région de guidage de bande induit un déplacement de la bande (12) ;
la formation du coussin non gazeux en tant que coussin solide (116) ;
la transformation du coussin non gazeux au sein d'un second espace intermédiaire (111) en un coussin de gaz (118) pendant un processus de dépôt appliquant de la chaleur sur la bande (12), le second espace intermédiaire (111) suivant le premier espace intermédiaire (110) dans une direction de rotation (113) du tambour (100) ;
le refroidissement de la bande (12) pendant un processus de dépôt appliquant de la chaleur sur la bande (12) au moyen du coussin de gaz (118).

14. Procédé permettant de revêtir une bande (12) dans un processus de revêtement dans des conditions sous vide comprenant :
- la régulation de la température de la bande (12) conformément au procédé selon l'une quelconque des deux revendications précédentes ; et
- le dépôt d'un matériau de revêtement sur la bande (12) par dépôt chimique en phase vapeur, dépôt physique en phase vapeur tel qu'évaporation ou pulvérisation, ou dépôt chimique en phase vapeur assisté par plasma.

15. Dispositif de commande comprenant : un processeur et une mémoire stockant des instructions qui, lorsqu'elles sont exécutées par le processeur, amènent un appareil de revêtement de bande à effectuer un procédé selon l'une quelconque des revendications 12 à 14.
